(19) Europäisches Patentamt
European Patent Office
Office européen des brevets

(11) **EP 4 769 475 A1**

(12) **EUROPEAN PATENT APPLICATION**

(43) Date of publication:
**01.07.2026 Bulletin 2026/27**

(21) Application number: **25226297.7**

(22) Date of filing: **22.12.2025**

(51) International Patent Classification (IPC):
***H01J 37/26*** (2006.01)

(52) Cooperative Patent Classification (CPC):
**H01J 37/263;** H01J 2237/226; H01J 2237/2614;
H01J 2237/2802

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **30.12.2024 US 202419005530**

(71) Applicant: **FEI COMPANY**
**Hillsboro, OR 97124 (US)**

(72) Inventor: **BUIJSSE, Bart**
**Eindhoven (NL)**

(74) Representative: **Boult Wade Tennant LLP**
**Salisbury Square House**
**8 Salisbury Square**
**London EC4Y 8AP (GB)**

(54) **OFF-PLANE IMAGING MODE FOR A LASER PHASE PLATE**

(57) Phase contrast images in a charged-particle beam system are obtained by directing a CPB as modulated by a sample to a phase plate to have a diffraction plane that is displaced from the phase plate. Based on interference fringes in the images, a transverse displacement of the CPB with respect to the phase plate can be estimated and adjusted.

FIG. 1B

**Description**

**FIELD**

The disclosure pertains to phase-dependent charged-particle beam imaging.

**BACKGROUND**

Phase contrast microscopy offers numerous imaging advantages but implementing the necessary phase plates in charged particle beam (CPB) imaging can be challenging. Some phase plates that have been developed put additional material in the CPB path to provide the necessary phase difference. A so-called Zernike phase plate based on a thin film with a central aperture can provide a suitable phase shift with proper thin film thickness. Such a phase plate and other phase plates based on insertion of thin film layers into a CPB tend to introduce unwanted scattering, exhibit damage or phase changes in response to CPB exposure, and/or produce phase changes based on phase plate charging.

One approach to producing the necessary phase changes in CPB imaging that can avoid these difficulties is based on a laser phase plate in which a periodic optical field of sufficient intensity is established to produce a suitable CPB phase shift based on the pondermotive potential associated with the periodic optical field. In most practical examples, the periodic optical field is established by directing a laser beam into a high finesse Fabry-Perot resonator to establish a standing wave optical field. Such systems are described in, for example, Axelrod, "A Laser Phase Plate for Transmission Electron Microscopy," available at https://arxiv.org/abs/2403.10670, submitted March 15, 2024, and Axelrod et al., "Modern Approaches to Improving Phase Contrast Electron Microscopy," available at https://arxiv.org/abs/2401.11678, submitted January 22, 2024, both of which are incorporated herein by reference. For successful imaging with a laser phase plate, the phase plate (i.e., the standing wave optical field) and the CPB must be well-aligned and the alignment must be stable. Unfortunately, maintaining stable alignment of a CPB to within a fraction of a wavelength of the standing wave optical field is difficult, and in conventional approaches, imaging is halted to permit realignment. This introduces additional complexity, delay, and inefficiency in phase imaging and alternative approaches are needed.

**SUMMARY**

The disclosed methods and apparatus are illustrated with reference to CPBs generally, and typical important practical applications include phase dependent electron beam imaging such as TEM. Phase contrast CPB imaging methods and apparatus are disclosed in which a phase plate such as a laser phase plate is situated to be displaced from a diffraction plane associated with a specimen. In some examples, the diffraction plane is a back focal plane of an objective lens used to image the specimen. This imaging condition is referred to as off-plane imaging. In methods and systems implementing off-plane imaging, alignment of a CPB with respect to a phase plate can be determined and corrected as needed. This is especially useful in applications that include a laser phase plate which provides a periodic phase modulation of period equal to $\lambda/2$, wherein $\lambda$ is a laser wavelength.

The foregoing and other features and advantages of the disclosed technology will become more apparent from the following detailed description, which proceeds with reference to the accompanying figures.

**BRIEF DESCRIPTION OF THE DRAWINGS**

FIGS. 1A-1B illustrate situating a diffraction plane associated of a charged-particle beam (CPB) optical system at a phase plate or at a location axially displaced from a phase plate, respectively.

FIG. 1C illustrates a periodic phase distribution produced with a laser phase plate corresponding to a standing wave optical field.

FIGS. 1D-1E correspond to FIGS. 1A-1B showing phase distributions applied to a CPB by a laser phase plate with a diffraction plane situated at the laser phase plate (FIG. 1D) or at a location displaced from the laser phase plate (FIG. 1E). In FIGS. 1D-1E, CPB alignment with respect to the standing wave optical field is superimposed.

FIG. 1F illustrates a CPB diffraction plane situated at a location axially displaced from a laser phase plate and with a transverse offset selected to vary image contrast.

FIG. 1G illustrates broken Friedel symmetry with zero transverse offset.

FIG. 2A illustrates a sample image obtained with a CPB diffraction plane associated with a sample situated at a location axially displaced from a laser phase plate.

FIG. 2B illustrates summed image intensity of the sample image of FIG. 2A as a function of position along a direction associated with a periodic phase associated with a standing wave optical field produced by a laser phase plate.

FIG. 3A illustrates simulated image modulation associated with varying CPB diffraction plane displacements from a location of a laser phase plate. In FIG. 3A, displacements increase from left to right and top to bottom, starting at $\Delta = 0$ and increasing by a fixed increment.

FIG. 3B illustrates summed image intensities corresponding to the simulated images of FIG. 3A illustrating an increase in fringe visibility with increasing values of $\Delta$.

FIG. 3C illustrates CPB alignment with respect to a phase plate having a periodic phase at various locations to select image contrast.

FIG. 3D illustrates images obtained using the alignments of FIG. 3C.

FIG. 4 illustrates a representative method of CPB imaging with a laser phase plate.

FIG. 5 illustrates a CPB imaging apparatus that includes a laser phase plate and that is operable to situate a CPB diffraction plane to have a displacement from the laser phase plate and control phase plate transverse offset based on acquired images.

FIG. 6 illustrates a representative computing environment for control and operation of an apparatus such as illustrated in FIG. 5.

FIGS. 7A-7B illustrate additional representative locations for phase plates.

FIG. 8 illustrates a representative method of adjusting images in response to broken Friedel symmetry.

## DETAILED DESCRIPTION

The disclosure pertains to methods and apparatus for maintaining alignment of a CPB, in particular, a CPB diffraction plane, and a phase plate using images acquired with the phase plate. The examples are described with reference to a laser phase plate in which phase variations are based on a pondermotive force associated with a standing wave optical field which can conveniently be provided with a laser beam directed into a Fabry-Perot optical resonator. It is generally more convenient to adjust CPB position than to adjust the positions of the standing wave optical field and for this reason, the examples below describe systems and methods in which CPB position is adjusted although in other examples, the standing wave optical field could be repositioned by, for example, repositioning the associated Fabry-Perot resonator or adjusting laser wavelength. Although described with reference to a phase plate having that produces spatially varying phase shifts based on the periodic intensity and field variations of the standing wave optical field, the disclosed methods and apparatus can be used with other phase plates that provide spatially varying phases.

The standing wave optical field produced by the laser phase plate produces a periodically varying phase in which maximum phase modulation is provided at antinodes and minimum (usually no) modulation is provided at nodes. For a standing wave optical field of wavelength $\lambda$, the associated phase modulation which is dependent on optical intensity has a period of $\lambda/2$. In typical examples, the standing wave optical field is provided by a laser such as an Nd:YAG laser and one or more fiber optical amplifiers or other laser system operating at or near 1064 nm. With this wavelength used to produce the standing wave optical field, CPB positioning with respect to this standing wave optical field is preferably selected and maintained within $\lambda/10$. $\lambda/20$ or less. The disclosed methods permit establishing suitable alignment to a phase plate and maintaining such alignment without interruption of imaging, if desired.

Furthermore, as used herein, a laser phase plate system refers to a system used to generate a suitable standing wave optical field and includes laser source, fiber amplifier, Fabry-Perot interferometer and other optical elements and systems needed to produce, control, and stabilize the standing wave optical field such as illustrated in the Axelrod references cited above. In referring to CPB propagation in an optical column, laser phase plate refers to a region in which a standing optical wave field is present, typically a region defined by a Fabry-Perot resonator. It is generally preferred to direct a CPB to a portion of this standing wave optical field that is situated within a Rayleigh range of a beam waist which is typically provided in a Gaussian optical beam having a circular cross-section but other beam shapes and positions can be used. It will be appreciated that reference to a standing wave optical field as a phase plate means that the phase plate location is defined by the location of the standing wave optical field and not by the presence of any physical device. The disclosed methods and apparatus can be used with other types of phase plates as well but for purposes of illustration, use of a laser phase plate system is described in detail herein.

### General Terminology

As used herein, "image" refers to visual presentation for viewing such by a technician, operator, or other person on display device, a projection on a surface such as projection screen, or otherwise presented for viewing. "Image" also refers to numerical representations of viewable images such as in image files in JPG, TIFF, BMP, or other formats. Such numerical representations include or are processable to produce values of intensity as a function of position, $I(X,Y)$, wherein X and Y are coordinates along linearly independent (and typically orthogonal) axes. In the examples described herein, intensity is presented as a single value without reference to color as would be viewed by an observer. However, intensity values can be assigned to one or more spectral components such as red, green, and blue for viewing, or other image values such as hue, saturation, and value, or color coordinates (for example LAB, CYMK, RGB) can be used. In the examples, the images of interest are charged-particle beam (CPB) images and a single intensity value is appropriate.

Numerical representations of images can be referred to sample location based on intensity values $I(X,Y)$ for ranges of spatial coordinates. Alternatively, images can be represented as arrays or other sets of intensity values $I(J,K)$, wherein $J,K$ are nonnegative integers denoting pixel locations corresponding to sample locations. Mappings of pixel locations $(J,K)$ to image coordinates $(X,Y)$ depends on sample placement and image magnifications. In some cases, arrays of intensities $I(J,K)$ are obtained with an array detector but non-array detectors can also be used. Intensity is generally associated with charge or current at individual pixels and can be a linear or other function of charge or current. The examples are described with respect to right-handed Cartesian coordinate systems in which a Z-axis is generally associated with a CPB optical axis and X- and Y-directions are orthogonal to the Z-axis and are thus associated with transverse displacements.

As noted above, examples are described with reference to laser phase plates in which a standing wave optical field is established to produce suitable CPB phase shifts based on the pondermotive potential associated with the periodic optical field. As discussed above, in most practical examples, the periodic optical field is established by directing a laser beam into a high finesse Fabry-Perot resonator to establish a standing wave optical field having sufficient intensity to produce a periodic CPB phase shift of sufficient amplitude. In some examples, the amplitude of the phase shift can be set as $\pi/2$, but other values can be chosen, and this value can be used for convenient explanation. Amplitude of a standing wave optical field in a Fabry-Perot resonator is described as a Gaussian beam, preferably in a lowest order mode, having a beam waist $w_0$ that can be selected to provide a suitable beam intensity for production of the pondermotive potential. Convenient values are typically between 2 $\mu$m and 20 $\mu$m inclusive. In addition, $w_0$ can be selected to provide a sufficiently large Rayleigh range over which the Gaussian beam spread is acceptable, with typical values between 50 $\mu$m and 200 $\mu$m inclusive.

As used herein, a CPB is described as being directed along an axis toward a sample, a phase plate, and a detector such as an image detector. A displacement along the axis of a CPB diffraction plane from a location of the phase plate is referred to herein as a "diffraction plane displacement" represented as $\Delta$ and is generally illustrated along a Z-axis. Typically, a diffraction plane is located at a focal plane of a CPB lens or set of CPB lenses (such as a back focal plane or a front focal plane) or a plane that is optically conjugate to such a focal plane. Imaging with $\Delta = 0$ can be referred to as "on-plane imaging" while imaging with non-zero values of $\Delta$ is referred to as "off-plane imaging." A displacement of a peak value or other specified value of phase (or antinode or other portion of a standing wave optical field in a laser phase plate) in a direction orthogonal to the axis is referred to herein as a transverse offset. In the examples, the transverse offset is typically associated with a peak value of phase associated with a phase plate (such as an antinode) for convenient explanation. The standing wave optical field defines a laser phase plate having nodes and antinodes that are periodic along an X-direction that is transverse to a CPB axis. A direction along which the standing optical field exhibits periodic variation between nodes and antinodes is referred to herein as a "phase axis." In the example, phase axes are typically along an X-axis of a coordinate system used for description. Generally, diffraction plane displacements $\Delta$ from an objective lens back or front focal planes are used but other lenses can be used to produce suitable conjugate planes. It is generally convenient to set a diffraction plane displacement $\Delta$ using one or more CPB optical components but a phase plate can be translated as needed. For purposes of illustration, examples are shown in which a laser phase plate is situated with respect to a back focus of an objective lens that receives the CPB from a specimen. However, it can be convenient to situate a laser phase plate with respect to a conjugate plane using transfer optics that provide a magnification of between 1 and 5.

As used herein, "orthogonal" angles refers to angles that are 90 degrees $\pm 1$, $\pm 5$, $\pm 10$, or $\pm 15$ degrees.

As used in this application and in the claims, the singular forms "a," "an," and "the" include the plural forms unless the context clearly dictates otherwise. Additionally, the term "includes" means "comprises." Further, the term "coupled" does not exclude the presence of intermediate elements between the coupled items.

The systems, apparatus, and methods described herein should not be construed as limiting in any way. Instead, the present disclosure is directed toward all novel and non-obvious features and aspects of the various disclosed embodiments, alone and in various combinations and sub-combinations with one another. The disclosed systems, methods, and apparatus are not limited to any specific aspect or feature or combinations thereof, nor do the disclosed systems, methods, and apparatus require that any one or more specific advantages be present or problems be solved. Any theories of operation are to facilitate explanation, but the disclosed systems, methods, and apparatus are not limited to such theories of operation.

Although the operations of some of the disclosed methods are described in a particular, sequential order for convenient presentation, it should be understood that this manner of description encompasses rearrangement, unless a particular ordering is required by specific language set forth below. For example, operations described sequentially may in some cases be rearranged or performed concurrently. Moreover, for the sake of simplicity, the attached figures may not show the various ways in which the disclosed systems, methods, and apparatus can be used in conjunction with other systems, methods, and apparatus. Additionally, the description sometimes uses terms like "produce" and "provide" to describe the disclosed methods. These terms are high-level abstractions of the actual operations that are performed. The actual operations that correspond to these terms will vary depending on the particular implementation and are readily discernible by one of ordinary skill in the art.

In some examples, values, procedures, or apparatuses are referred to as "lowest", "best", "minimum," or the like. It will be appreciated that such descriptions are intended to indicate that a selection among many used functional alternatives can be made, and such selections need not be better, smaller, or otherwise preferable to other selections. Examples are described with reference to directions indicated as "above," "below," "upper," "lower," and the like. These terms are used for convenient description, but do not imply any particular spatial orientation. Specific coordinate systems are used for explanation only.

## *Example 1*

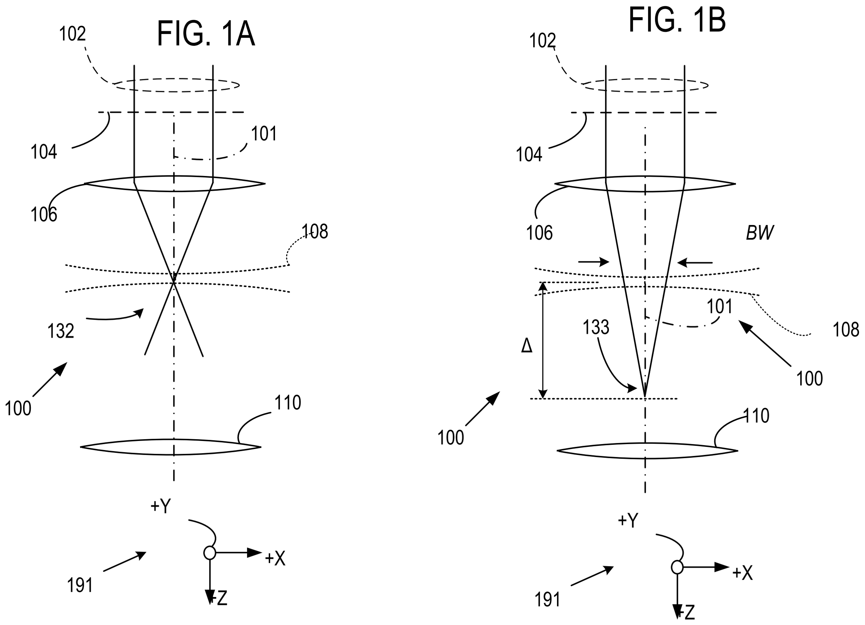

FIG. 1A illustrates a portion of charged-particle beam optical (CPB) system 100 that produces a CPB 102 that is directed to a sample 104 along an axis 101. The CPB 102 is generally produced, focused, scanned, and otherwise manipulated by additional CPB optical elements that are included in an optical column, but this optical column is not included in FIG. 1A. After interacting with the sample 104, the CPB 102 is directed with a CPB lens 106 to a diffraction plane 132 that is at or proximate a CPB phase plate 108 (shown schematically with a profile of a Gaussian optical beam) along the axis 101. Although focus to a point at the diffraction plane 132 is illustrated, the CPB 102 includes portions focused at different transverse locations along X- and Y-axes of a coordinate system 191 associated with differing spatial frequency components of the sample 104. An objective 110 receives the CPB 102 from the sample 104 and the phase plate 108 and produces an image that is dependent on the phase applied by the phase plate 108. In this example, the phase plate 108 is situated in a back focal plane of the CPB lens 106.

The arrangement of FIG. 1A requires that the CPB 102 maintain alignment with the phase plate 108. Otherwise, misalignment of the phase plate 108 and the CPB 102 manifests as features in a sample image that are a sub-optimal representation of sample structure. Stable alignment of phase plates is generally difficult. For phase plates that exhibit rapid variation in phase as a function of position, stable alignment is especially challenging. For example, for a laser phase plate, variations in phase are periodic with a period based on a standing wave optical field wavelength, such as 1064 nm. Alignment of the CPB and the phase plate should be stable withing a fraction of this wavelength, such as, for example, within 5%, 2,5%, or 1% or less, i.e., within about 52 nm, 27 nm, or 13 nm, or less. Not only can it be challenging to align a CPB and the phase plate with such tight tolerances, but the alignment is also to be maintained during imaging. Referring to FIG. 1B, the CPB lens 106 is situated to produce a CPB beam focus 133 at a diffraction plane displacement $\Delta$ axially displaced (i.e., along a Z-axis parallel to the axis 101 either upstream or downstream or at an optically conjugate location) from the phase plate 108. With this arrangement, the CPB 102 has a beam width *BW* at the phase plate 108 so that different portions of the CPB 102 experience different phase shifts due to the varying phase associated with the phase plate 108.

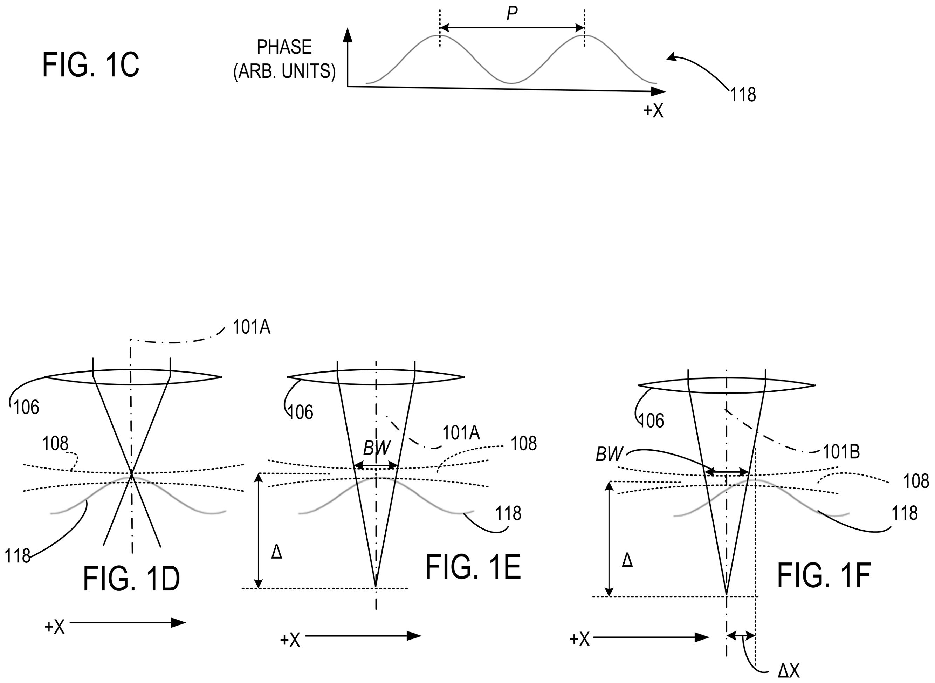

FIG.1C illustrates a periodic phase variation 118 of period P associated with a representative phase plate such as the laser phase plate 108 in which the phase variation is based on a standing wave optical field of wavelength $\lambda$. For a laser phase plate, the period P = $\lambda$/2. For purposes of illustration, the laser phase plate 108 is shown as an envelope of a Gaussian beam with an exaggerated rate of beam expansion away from the beam waist and the amplitude of the periodic phase variation 118 is substantially constant as shown in FIG. 1C. For example, the periodic phase variation typically has a period based on the wavelength of the optical beam used to produce the periodic phase variation 118 (on the order of 1 $\mu$m) while the Gaussian beam has a Rayleigh range of on the order of 150 $\mu$m. FIG. 1D illustrates the configuration of FIG. 1A with respect to this periodic phase variation while FIG. 1E illustrates the configuration of FIG. 1B showing the phase variation experienced by the CBP 102 with the diffraction plane displacement $\Delta$ but aligned with respect to the CPB 102. FIG. 1F illustrates the phase plate 108 with phase plate transverse offset $\Delta$X. In the configuration of FIG. 1F, an image produced by the objective 110 includes image features that can be used to assess and correct or establish CPB/phase plate alignment as discussed in detail below.

### *Detection and Compensation of Phase Plate Transverse Offset with Sample Images*

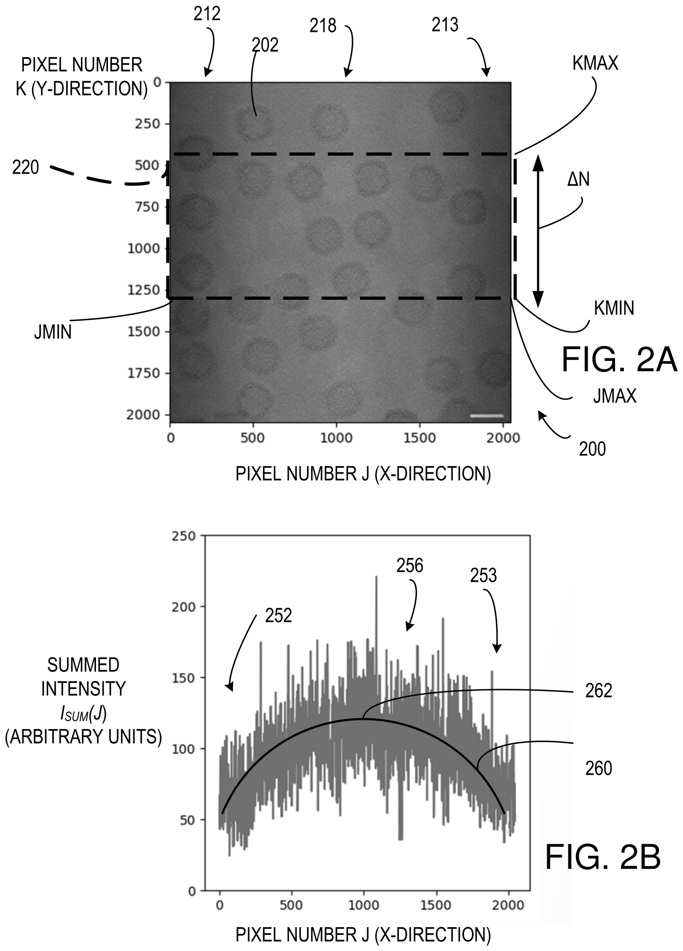

FIG. 2A is a sample image 200 obtained with a CPB/phase plate that includes image portions such as representative image portion 202 that is associated with a particle or other sample feature. For convenience, the sample image 200 can be divided into an N by M array of pixels, wherein each pixel is associated with an image intensity I and coordinates (J,K) to produce an image intensity I(J,K), wherein J, K, N, and M are nonnegative integers, with $J \le M$ and $K \le N$. The array can be arranged to extend to correspond to total distances $\Delta$X and $\Delta$Y at the sample 200 along orthogonal X- and Y-axes, respectively, based on sample orientation and magnification. In this example, a phase direction associated with the laser phase plate is a function of distance in an X-direction so that phase shifts produced by the phase plate are functions of X. The image intensity I(J,K) includes a phase contrast image $I_{PC}$(J,K) produced by different phase shifts imparted to the CPB due to differing spatial frequency components in the sample and an intensity variation $I_{\varphi}$(J) produced by phase variation $\varphi$(J) across the CPB beam due to displacement of the diffraction plane from the phase plate. With the orientation of the image 200 selected so that the X-direction (or J values) are associated with a direction of a phase variation in the laser phase plate, $I_\varphi(J)$ is a function of J only and not K. For other image alignments, $I_\varphi$ could be a function of one or both of J and K (or X- and Y-directions as referred to a sample). In conventional approaches to imaging with a laser phase plate, the diffraction plane is situated at the phase plate and the phase variation $\varphi = 0$ and $I_\varphi(J,K) = 1$. However, with a diffraction plane displacement $\Delta$ from the phase plate, the CPB has a beam width $BW$ at the phase plate. With a CPB that is directed along an axis having a transverse offset from an antinode or node of the standing wave optical field, portions of the CPB at different sides (i.e., different spatial frequency components) of the CPB can experience asymmetric phase shifts and the different phase portions when combined in an image produce an intensity modulation in the image. This intensity modulation is periodic with transverse offset $\Delta X$ and the images are Ronchigram images showing laser fringes. As used herein, such intensity modulations are referred to herein as a laser fringes. The extent of the fringe modulation in the image depends on the diffraction plane/phase plate displacement $\Delta$ as shown in the examples below.

Referring further to FIG. 2A, the sample image 200 includes image side portions 212, 213 along left and right sides that are relatively darker than a central portion 218 as a result of phase variation $\varphi(X)$ produced by the diffraction plane displacement $\Delta$. Relative position of the CPB and the standing wave optical field can be determined from the sample image 200 using these intensity variations as follows. A window such as representative window 220 is selected to extend to include some portions of the image side portions 212, 213 and the central portion 218. In this example, the window 220 extends to cover all pixels along the X-axis and $\Delta N$ pixels along the Y-direction, wherein $\Delta N$ can be selected to span the sample image 200 in the Y-direction or include only some portions. Intensities $I(J,K)$ for all K-values in the window 220 are summed for each J-value in the window. As an example, for a window width (X-axis or phase direction) that includes pixels for J a range (JMIN,JMAX) and pixels associated with the Y-axis (orthogonal to the phase axis) in range (KMIN,KMAX), a sum $I_{SUM}(J)$ is computed for each value of J:

$$I_{SUM}(J) = \sum_{K=KMIN}^{K=KMAX} I(J,K).$$

The computed values $I_{SUM}(J)$ can be scaled by a constant factor and whether scaled or not, are referred to herein as the summed intensities $I_{SUM}(J)$. An example of a summed intensity is plotted in FIG. 2B and includes portions 252, 253 corresponding to image side portions 212, 213 and a portion 256 corresponding to central portion 216. The presence of particles such as particles or other sample features tends to produce a noise-like appearance, and larger heights of the window 220 in a Y-direction tend to produce summed intensities that are less noise like.

A peak of the summed intensity $I_{SUM}(J)$ occurs at a J-value associated with a peak of the phase modulation associated with the laser phase plate, i.e., at an antinode location of the standing wave optical field. This is shown in FIG. 2B as a peak 262 of a curve fit 260 to the summed intensity $I_{SUM}(J)$. Based on the location of this peak, any displacement of the CPB from the antinode location can be determined and corrected. It is generally more convenient to adjust CPB position at the laser phase plate and one or more CPB lenses or deflectors are operated to correct the measured displacement. In this way, the CPB can be maintained at a selected laser phase plate location while imaging and without operator intervention. In addition, the summed intensity $I_{SUM}(J)$ can be used to compensate variations in image intensities due to the CPB focus shift by adjusting image intensities $I(J,K)$ by a factor proportional or otherwise a function of $1/I_{SUM}(J)$ for each J.

It will be appreciated that for some values of phase variation $\varphi$ (i.e., some diffraction plane displacements $\Delta$), image intensity can be too low with respect to noise for useful imaging and correction of low intensities is not likely to be especially useful. However, for phase variations $\varphi$ of at least 90 degrees, the procedure described above can be successful. In the example of FIGS. 2A-2B, the CPB is directed generally toward an antinode location of the laser phase plate; CPB location and correction as well as intensity compensation can be performed with the CPB directed at locations other than antinodes such as nodes but generally placements of less than 50 nm from an antinode are preferred.

### Sample Images with Various Phase Plate Transverse Offsets

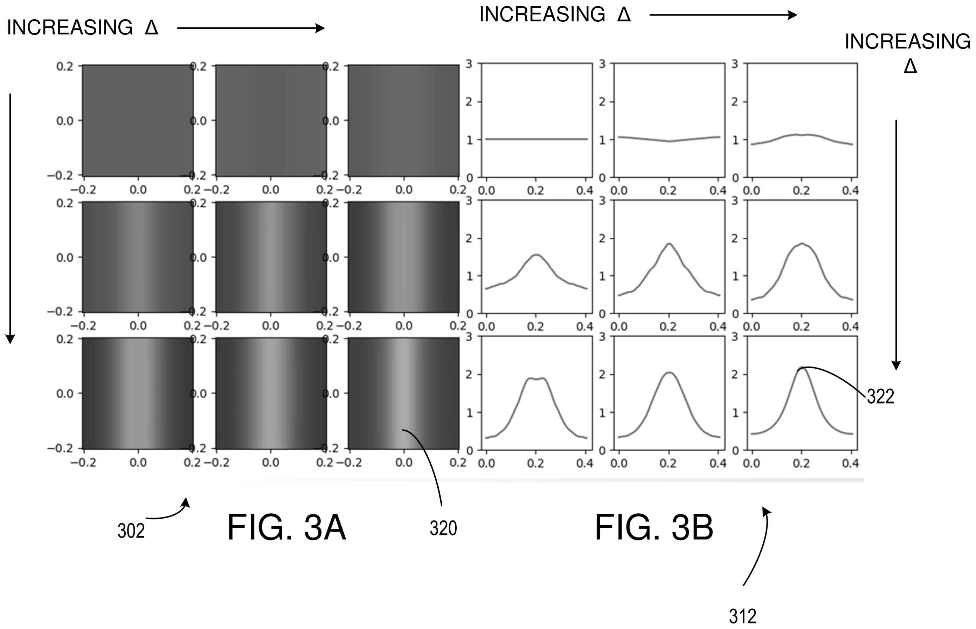

FIG. 3A includes a set 302 of simulated sample images obtained with various values of diffraction plane displacement $\Delta$, with $\Delta$ increasing in the images from left to right and then top to bottom by a fixed increment, with the upper leftmost image associated with $\Delta = 0$. FIG. 3B includes a set 312 of simulated summed intensities along a phase variation direction corresponding to diffraction plane displacements $\Delta$ of the simulated sample images of FIG. 3A. The sample images and the simulated summed intensities show that as the diffraction plane displacement $\Delta$ increases, fringes become more apparent. Using the summed intensities of FIG. 3B, CPB location with respect to the periodic phase of the laser phase plate can be determined and the CPB (or the laser phase plate) can be shifted so that the CPB is incident to the phase plate at the selected location which need not be a node or antinode but can be any location. However, it is convenient if the maximum intensity is still visible in the image, otherwise the image quality may be so compromised and it can be difficult to determine the correction that needs to be made to put the beam back at an antinode. For example, a peak 322 of the summed intensity associated with the bottom rightmost image 320 corresponds to a location of an antinode of a periodic phase modulation and can be used to confirm or adjust CPB/phase plate alignment.

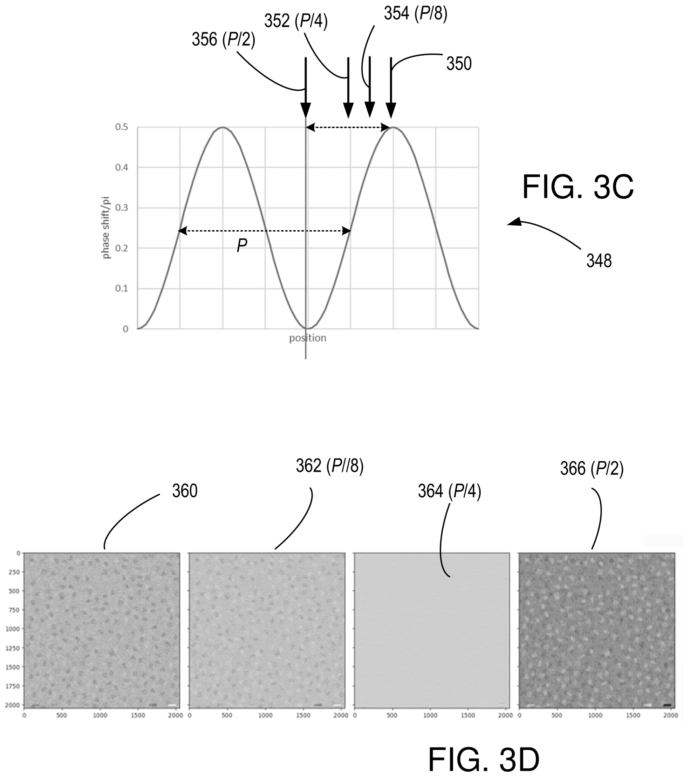

In some examples, CPB/phase plate alignment is selected and controlled to maintain CPB incidence to an antinode of the periodic phase provided by a phase plate to provide contrast for low spatial frequency features in a sample. However, other alignments can be selected. As shown in FIG. 3C, a CPB can be incident to a periodic phase variation 348 of period $P$ at an antinode 350, a node 356 offset from the antinode by $P/2$, at a position 352 offset from the antinode by $P/4$, or at a position 354 offset from the antinode by $P/8$. Incidence at the antinode 350 produces images such as shown in FIG. 3A; incidence at the position offset from the antinode by $P/4$ produces an image with little or no intensity variation due to phase contrast, incidence at the position offset from the antinode by $P/8$ produces an image with reduced phase contrast, and incidence at the node 356 produces an image with reverse contrast from that produced with the CPB directed to an antinode. FIG. 3D includes representative images 360, 362, 364, 366 associated with CPB transverse offsets from an antinode by 0, $P/8$, $P/4$, and $P/2$, respectively, with the diffraction plane displacement $\Delta = 0$.

### Phase Plate/CPB Alignment

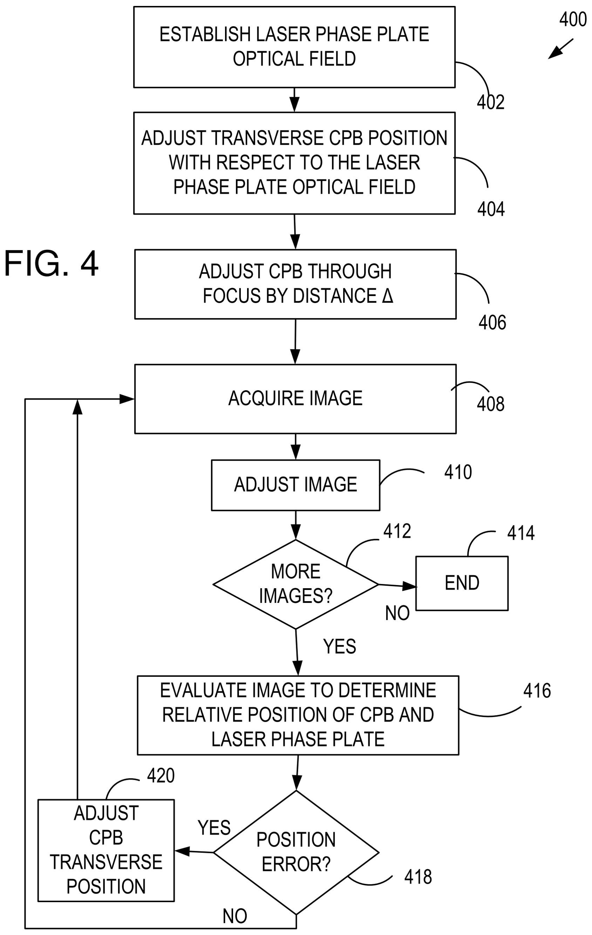

Referring to FIG. 4, a representative method 400 includes establishing a standing wave optical field to produce a laser phase plate that produces a periodic phase shift on a CPB at 402. At 404, a CPB focus and the laser phase plate are offset to produce a selected CPB/phase alignment, typically so that the CPB is directed to an antinode of a periodic phase provided by the phase plate. At 406, a CPB diffraction plane displacement $\Delta$ is established by adjusting CPB beam focus or suitable positioning of the phase plate. As noted previously, it is generally more convenient to adjust CPB focus and position than adjust a laser phase plate. At 408, an image is acquired. At 410, the acquired image can be adjusted based on, for example, summed values of acquired image intensity $I_{SUM}$ as discussed above to remove or diminish intensity variations associated with portions of a fringe appearing in the acquired image. At 412 it is determined if additional images are to be acquired, and if not, processing ends at 414. Otherwise, at 416, the acquired image is evaluated, typically based on $I_{SUM}$, to determine the transverse offset between the CPB and the phase plate. If a position error is noted at 418 based on the determined transverse offset, at 420, the transverse offset can be adjusted as needed at 420 and processing returned to 408 for acquisition of additional images.

In the example above, an initial transverse offset of the CPB and phase plate can be established based on one or more images, with or without operator intervention. Images need not be corrected to remove fringe effects but can be evaluated only to monitor and correct transverse offset. The diffraction plane displacement $\Delta$ can also be selected and adjusted as needed. Some or all images can be evaluated to monitor CPB/phase plate transverse offset, or images can be selected randomly, periodically, or in response to operator intervention.

### Representative CPB Imaging System with Laser Phase Plate

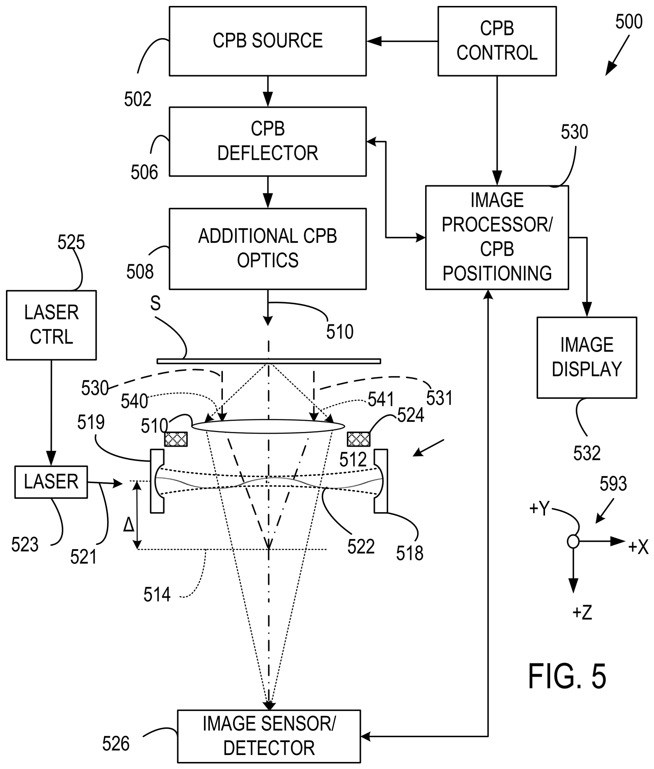

Referring to FIG. 5, a representative CPB imaging system 500 includes a CPB source 502 that produces a CPB 510 that is directed by a deflector 506 and additional CPB optics 508 such as deflectors, lenses, apertures, stigmators, or other optical elements to a sample S. After modulation by the sample S, an objective lens 510 directs the CPB through a laser phase plate system 516 and images the sample S at an image sensor 526 or other detector or detection system. The objective lens 510 establishes a diffraction plane 514 shown in this example as a back focal plane of the objective lens 510. The laser phase plate system 516 is based on a Fabry-Perot resonator established by mirrors 518, 519 and a laser system such as laser and fiber amplifier 523 as controlled by a control system 525 that is operable to produce an optical beam 521 that is directed into the Fabry-Perot resonator to establish a standing wave optical field 522. The control system 525 can measure and adjust the laser system 523 and other parameters to stabilize the standing wave optical field 522. In addition, the relative transverse position of the standing wave optical field 522 with respect to the CPB along X- and Y-axes of a coordinate system 593 can be adjusted using one or more actuators coupled to the control system 525 (not shown in FIG. 5), but generally control of CPB position with a beam deflector such as the CPB deflector 506 or other CPB optical element is more convenient. For example, a CPB deflector 524 can be situated downstream from the sample S to adjust CPB position with respect to the standing wave optical field 522. Such a CPB beam deflector can be situated upstream of or downstream of the objective lens 510. In some cases, additional transfer optical elements can be provided and one or CPB beam deflectors situated to adjust CPB position with respect the standing wave optical field 522.

The standing wave optical field 522 is schematically represented to show locations of nodes and antinodes. A spatial extent of the standing wave optical field 522 along the Z-axis corresponds to the beam mode, typically a lowest order Gaussian beam mode characterized by a beam waist. The standing wave optical field 522 is situated to be displace a distance $\Delta$ from the diffraction plane 514.

CPB imaging is illustrated with representative CPB propagation directions 540, 541 (shown as dotted lines) that are indicative of interaction of the CPB 510 with the sample S. A selected spatial frequency component produced by the sample S is illustrated with representative CPB propagation directions 530, 531 (shown as dashed lines) associated with focus at the diffraction plane 514. For purposes of illustration, the CPB propagation directions 530, 531 can be associated with an a $0^{th}$ diffraction order portion of the CPB portion of the Other spatial frequency components are focused at different locations at the diffraction plane 514.

Processing of images to determine CPB/phase plate transverse offset by, for example, calculation of $I_{SUM}$, adjustment of CPB/phase plate transverse offset and diffraction plane displacement, and adjustment of images to compensate intensity variation due to fringes can be performed by one or more logical processors such as a CPU 530. Processed or unprocessed images can be directed to a display device 532 for user viewing or images can be communicated via a network or other connection for remote viewing, analysis, and any additional processing.

### *Representative CPB Control and Processing Systems*

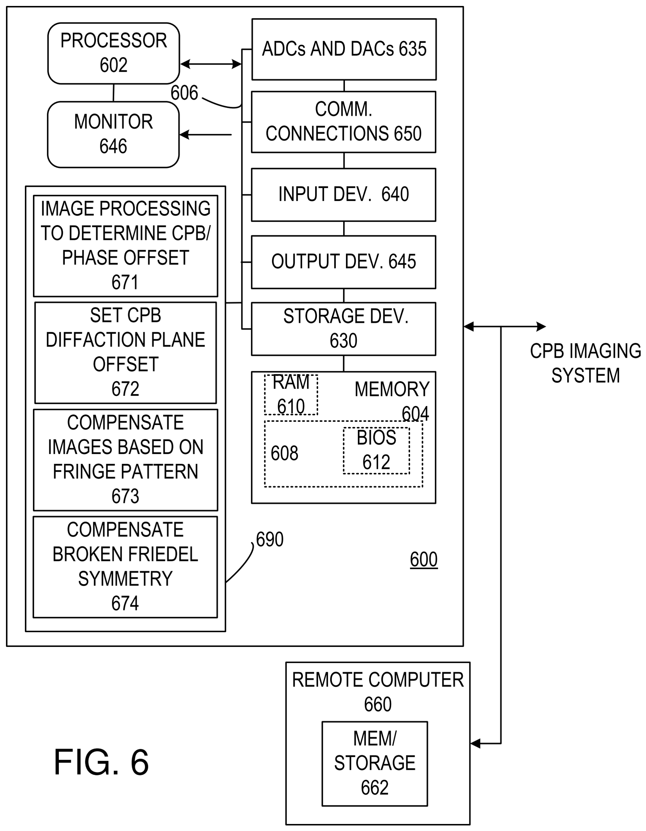

FIG. 6 and the following discussion are intended to provide a brief, general description of an exemplary computing environment in which the disclosed technology may be implemented. In particular, some or all portions of this computing environment can be used with the above methods and apparatus to, for example, control CPB positioning, focus, and diffraction plane displacement, process images to determine CPB /phase plate transverse offsets, correct or compensate images to eliminate or reduce intensity variations due to fringes, adjust phase plates, and generally control and process data associated with apparatus such as shown in FIG. 5. Although not required, the disclosed technology is described in the general context of computer-executable instructions, such as program modules, being executed by a personal computer (PC). Generally, program modules include routines, programs, objects, components, data structures, etc., that perform particular tasks or implement particular abstract data types. Moreover, the disclosed technology may be implemented with other computer system configurations, including hand-held devices, multiprocessor systems, microprocessor-based or programmable consumer electronics, network PCs, minicomputers, mainframe computers, and the like as well as with FPGAs, ASICs, Complex Programmable Logic Devices (CPLDs), or other dedicated processors. The disclosed technology may also be practiced in distributed computing environments where tasks are performed by remote processing devices that are linked through a communications network. In a distributed computing environment, program modules may be located in both local and remote memory storage devices. As used herein, storage and storage devices refer to physical devices and not transitory storage or signals.

With reference to FIG. 6, an exemplary system for implementing the disclosed technology includes a general-purpose computing device in the form of an exemplary conventional PC 600, including one or more processing units 602, a system memory 604, and a system bus 606 that couples various system components including the system memory 604 to the one or more processing units 602. The system bus 606 may be any of several types of bus structures including a memory bus or memory controller, a peripheral bus, and a local bus using any of a variety of bus architectures. The exemplary system memory 604 can include read only memory (ROM) 608 and random-access memory (RAM) 610 and a basic input/output system (BIOS) containing the basic routines that help with the transfer of information between elements within the PC 600, can be stored in the ROM 608.

The exemplary PC 600 further includes one or more storage devices 630 such as a hard disk drive for reading from and writing to a hard disk, a magnetic disk drive for reading from or writing to a removable magnetic disk, and an optical disk drive for reading from or writing to a removable optical disk (such as a CD-ROM or other optical media). Such storage devices can be connected to the system bus 606 by a hard disk drive interface, a magnetic disk drive interface, and an optical drive interface, respectively. The drives and their associated computer-readable media provide nonvolatile storage of computer-readable instructions, data structures, program modules, and other data for the PC 600. Other types of computer-readable media which can store data that is accessible by a PC, such as magnetic cassettes, flash memory cards, digital video disks, CDs, DVDs, RAMs, ROMs, and the like, may also be used in the exemplary operating environment. In the example of FIG. 6, one or more memories or other storage devices 690 include portions 671, 672, 673, 674, respectively that store processor-executable instructions for image processing to determine transverse offset, set CPB diffraction plane displacement $\Delta$, compensate images based on fringe patterns, and compensate images for broken Friedel symmetry.

A number of program modules may be stored in the storage devices 630 including an operating system, one or more application programs, other program modules, and program data. For example, port location data can be stored in a storage device. A user may enter commands and information into the PC 600 through one or more input devices 640 such as a keyboard and a pointing device such as a mouse. Other input devices may include a digital camera, microphone, joystick, game pad, satellite dish, scanner, or the like. These and other input devices are often connected to the one or more processing units 602 through a serial port interface that is coupled to the system bus 606 but may be connected by other interfaces such as a parallel port, game port, or universal serial bus (USB). A monitor 646 or other type of display device is also connected to the system bus 606 via an interface, such as a video adapter. Other input and output devices 635 such as digital-to-analog converters (DACs) and analog-to-digital convertors (ADCs) may be included to provide control signals such as focus or other signals and receive signals from a CPB imaging apparatus.

The PC 600 may operate in a networked environment using logical connections to one or more remote computers, such as a remote computer 660. In some examples, one or more network or communication connections 650 are included for wired or wireless communication as well as data acquisition and control such as digital-to-analog convertors and analog-to-digital convertors. The remote computer 660 may be another PC, a server, a router, a network PC, or a peer device or other common network node, and typically includes many or all of the elements described above relative to the PC 600, although only a memory or storage device 662 has been illustrated in FIG. 6. The personal computer 600 and/or the remote computer 660 can be connected to a local area network (LAN) and a wide area network (WAN). Such networking environments are commonplace in offices, enterprise-wide computer networks, intranets, and the Internet.

When used in a LAN networking environment, the PC 600 is connected to the LAN through a network interface. When used in a WAN networking environment, the PC 600 typically includes a modem or other means for establishing communications over the WAN, such as the Internet. In a networked environment, program modules depicted relative to the personal computer 600, or portions thereof, may be stored in the remote memory storage device or other locations on the LAN or WAN. The network connections shown are exemplary, and other means of establishing a communications link between the computers may be used.

### *Additional Representative Phase Plate Locations*

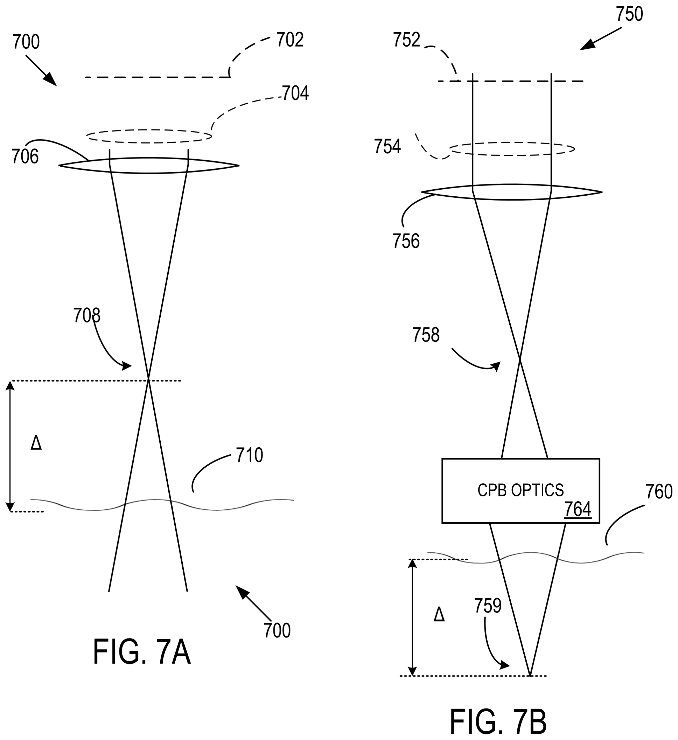

A laser phase plate can be positioned in other locations as illustrated in FIGS. 7A-7B. Referring to FIG. 7A, a CPB 704 from a specimen 702 is directed to a lens 706 that focuses the CPB at 708. The CPB focus 708 is situated optically upstream of a phase plate 710 by a distance $\Delta$ in contrast to examples such as in FIG.1B where the CPB focus is downstream of the phase plate. Referring to FIG. 7B, a CPB 754 from a specimen 752 is directed to a CPB objective lens 756 having a back focus at at 758. The CPB focus 758 is reimaged by other CPB optics 764 and a phase plate is displaced by a distance $\Delta$ from a location 759 that is optically conjugate to the back focus 758. In FIG. 7B, the optically conjugate location 759 is optically downstream of the phase plate 760 but in other examples is situated upstream. In general, phase plates are situated at locations displaced a distance $\Delta$ optically upstream or downstream of CPB focus downstream of a specimen or at locations conjugate to such locations.

### **Phase Imaging with Broken Friedel Symmetry**

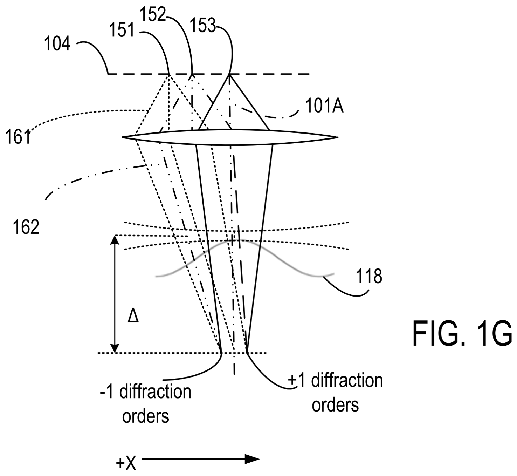

A specific spatial frequency in a sample gives rise to a so called +1 and -1 CPB scattering components that are referred to as "Friedel mates." Friedel symmetry is broken if the +1 and -1 components acquire different phase shifts when traveling to a camera. In some cases, a CPB is transmitted by a laser phase plate at the optical axis of the laser but is not well aligned to an antinode of the standing wave optical field (i.e., a highest-intensity region), thereby breaking Friedel symmetry for some part of the scattered wave. This symmetry breaking can occur for arbitrary values of the transverse offset $\Delta X$, including $\Delta X = 0$. Diffracted beams from different portions of a sample will be directed to different phase shift regions. As shown in FIG. 1G, beams diffracted at sample locations 151-153 interact with different portions of the periodic optical field 118. For example, a -1 diffraction order 161 associated with sample location 151 traverses the periodic optical field 118 at a different location than a -1 diffraction order 162 associated with the sample location 152 Thus, an image that has nominally no transverse offset $\Delta X$, correction can be applied.

The one-dimensional image intensity *I(x)* along an x-axis parallel to phase direction and associated with a single Fourier coefficient k of the sample image intensity without the phase plate can be written as:

$$I(x) = 1 - 2\sigma F(k) \cos\left(kx + \gamma(k) + \frac{\pi}{2}\right) - 2\sigma F(k) \cos\left(-kx + \gamma(k) + \frac{\pi}{2}\right)$$

wherein $\gamma(k)$ is an aberration function of the objective lens, *F(k)* is the Fourier transform of *I(x)/2σ*, wherein $\sigma = 2\pi e/hv$, *e* is the electron charge, *h* is Planck's constant, and v is electron velocity. Assuming that the aberrations are zero or can otherwise be neglected, the laser phase plate adds a phase shift which is different for the left and the right components due to the misalignment of the CPB with respect to the antinodes of the laser phase plate. Defining these phase shifts as $\gamma_l(k)$ and $\gamma_r(k)$ (left and right, respectively) with respect to the phase of the central beam,

$$I(x) = 1 - 2\sigma F(k) \cos\left(kx + \gamma_l(k) + \frac{\pi}{2}\right) - 2\sigma F(k) \cos\left(-kx + \gamma_r(k) + \frac{\pi}{2}\right).$$

This can be rewritten as:

$$I(x) = 1 - 2\sigma F(k) \left[ 2 \cos\left(\frac{\gamma_l(k) + \gamma_r(k) + \pi}{2}\right) \cos\left(\frac{2kx + \gamma_l(k) - \gamma_r(k)}{2}\right) \right]$$

The above can be simplified to:

$$I(x) = 1 - 4\sigma F(k) \cos(\bar{\gamma} + \pi/2) \cos(kx + \gamma_m),$$

wherein $\bar{\gamma} = \frac{\gamma_l(k) + \gamma_r(k)}{2}$ and $\gamma_m = \frac{\gamma_l(k) - \gamma_r(k)}{2}$. For example, if both $\gamma_l(k)$ and $\gamma_r(k)$ are $-\pi/2$, then $\bar{\gamma} = -\pi/2$ and $\gamma_m = 0$ so that $I(x) = 1 - 4\sigma F(k) \cos(kx)$. Generally, for different phase shifts (i.e., $\gamma_l(k) \neq \gamma_r(k)$), the Fourier components are altered by a constant factor constant $\cos(\bar{\gamma} + \pi/2) = -\sin(\bar{\gamma})$ for all Fourier components with a phase origin shift $\gamma_m$. By shifting the Fourier components to the proper phase origin (i.e., shifting the phase origin by $\gamma_m$), the image can be restored.

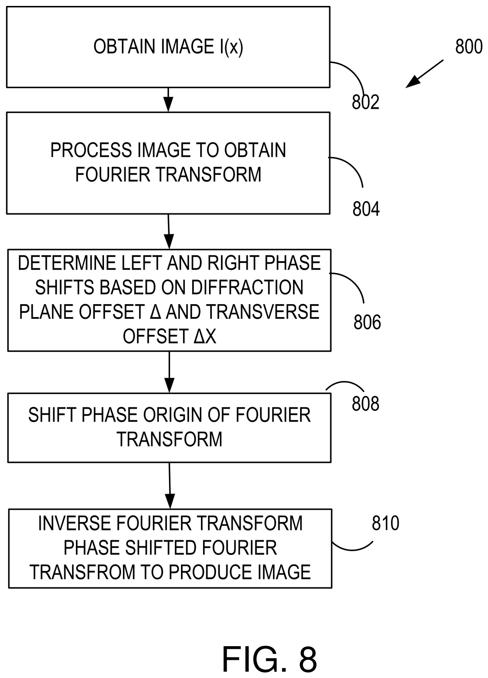

Referring to FIG. 8, a representative method 800 of restoring images to correct the effects of broken Friedel symmetry includes obtaining an image at 802 using a laser phase plate with a phase axis aligned in an x-direction. The measured image $I_M(x,y)$ is typically a two-dimensional image and line images associated with any value of $y$ can be selected and at 804, a Fourier transform of a selected line image is determined. At 808, left and right phase shifts are determined based on a diffraction plane displacement $\Delta$, transverse offset $\Delta X$, and period P of the phase modulation associated with the standing wave optical field. At 808, the origin of the Fourier transform is shifted based on a difference of left and right phase shifts (i.e., $\gamma_m$) as shown above. At 810, an inverse Fourier transform of the phase shifted Fourier transform is determined to produce an adjusted line image. This procedure is typically performed for each line image.

**Representative Disclosure Paragraphs**

Paragraph 1 is a method for CPB phase contrast imaging, including: situating a CPB phase plate to be irradiated by a charged particle beam (CPB) from a sample; situating the CPB phase plate to have a displacement $\Delta$ from a diffraction plane; and obtaining a sample image based on at least a portion of a CPB received from the CPB phase plate.

Paragraph 2 includes the subject matter of Paragraph 1, and further includes compensating the obtained sample image based on the diffraction plane displacement $\Delta$.

Paragraph 3 includes the subject matter of any of Paragraphs 1-2, and further includes determining a transverse displacement of the CPB with respect to the CPB phase plate based on the obtained sample image.

Paragraph 4 includes the subject matter of any of Paragraphs 1-3, and further includes adjusting a transverse position of the CPB with respect to the CPB phase plate based on the determined transverse displacement.

Paragraph 5 includes the subject matter of any of Paragraphs 1-4, and further specifies that the adjusting the transverse position of the CPB with respect to the CPB phase plate is performed by deflecting the CPB.

Paragraph 6 includes the subject matter of any of Paragraphs 1-5, and further specifies that the diffraction plane displacement $\Delta$ is selected so that the diffraction plane is optically downstream from the CPB phase plate.

Paragraph 7 includes the subject matter of any of Paragraphs 1-6, and further specifies that the CPB phase plate is a laser phase plate and the transverse displacement is associated with a separation of a CPB axis with respect to an antinode of a standing wave optical field established by the laser phase plate.

Paragraph 8 includes the subject matter of any of Paragraphs 1-7, and further specifies that the transverse displacement is less than or equal to P/8, and further specifies that P is a period of the standing wave optical field.

Paragraph 9 includes the subject matter of any of Paragraphs 1-8, and further includes identifying at least a portion of a laser fringe in the obtained sample image, wherein the transverse displacement of the CPB with respect to the laser phase plate is determined based on the portion of the laser fringe.

Paragraph 10 includes the subject matter of any of Paragraphs 1-9, and further includes adjusting intensity of at least selected portions of the sample image based on an amplitude of the laser fringe.

Paragraph 11 includes the subject matter of any of Paragraphs 1-10, and further specifies that the diffraction plane displacement is selected so that the portion of the laser fringe corresponds to less than P/Paragraph 2.

Paragraph 12 includes the subject matter of any of Paragraphs 1-11, and further specifies that the standing wave optical field produced by the laser phase plate extends and is periodic along an axis that is substantially orthogonal to the CPB axis and has a period based on a wavelength of the standing wave optical field, wherein the transverse displacement of the CPB axis from an antinode of the standing wave optical field is selected to be less than 1/10 of a period P of the standing wave optical field.

Paragraph 13 includes the subject matter of any of Paragraphs 1-12, and further includes adjusting an intensity of at least selected portions of the sample image based on an amplitude of the laser fringe.

Paragraph 14 includes the subject matter of any of Paragraphs 1-13, and further specifies that the CPB phase plate is a laser phase plate that defines a standing wave optical field, and further includes: combining sample image values in an image window along a direction that is orthogonal to a phase axis of the CPB phase plate to produce an image intensity profile; and based on the image intensity profile, determining a transverse displacement of the CPB axis from an antinode of the standing wave optical field.

Paragraph 15 is a charged particle beam (CPB) apparatus, including: a CPB phase plate situated to receive a CPB from a sample; and an objective lens situated to define a diffraction plane that is displaced a distance $\Delta$ from the CPB phase plate and form a sample image at a CPB detector, wherein the sample image is based on a phase applied to the CPB by the CPB phase plate.

Paragraph 16 includes the subject matter of Paragraph 15, and further includes an image processor operable to compensate the sample image based on the diffraction plane displacement $\Delta$.

Paragraph 17 includes the subject matter of any of Paragraphs 1-16, and further includes a controller coupled to receive the sample image and determine a transverse displacement of the CPB with respect to the CPB phase plate based on the sample image.

Paragraph 18 includes the subject matter of any of Paragraphs 1-17, and further specifies that the controller is coupled to a CPB deflector and is operable to adjust a transverse position of the CPB with respect to the CPB phase plate with the CPB deflector based on the determined transverse displacement.

Paragraph 19 includes the subject matter of any of Paragraphs 1-18, and further specifies that the controller is coupled to determine the transverse displacement based on a sum of image intensities along a direction that is orthogonal to a phase axis of the CPB phase plate.

Paragraph 20 includes the subject matter of any of Paragraphs 1-19, and further specifies that the sum of image intensities is obtained within a defined window, and the transverse displacement is obtained based on a location of an antinode of a standing wave optical field determined by the sum of image intensities.

Paragraph 21 includes the subject matter of any of Paragraphs 1-20, where the diffraction plane defined by the objective lens is a back focal plane or a front focal plane of the objective lens.

Paragraph 22 includes the subject matter of any of Paragraphs 1-21, and further specifies that the diffraction plane is situated at a plane optically conjugate back focal plane or a front focal plane of the objective lens.

Paragraph 23 includes the subject matter of any of Paragraphs 1-22, and further includes a controller coupled to receive the sample image adjust the sample image based on phase differences associated with a CPB transverse offset from a node or antinode of an optical standing wave field produced by a laser phase plate.

In view of the many possible embodiments to which the principles of the disclosure may be applied, it should be recognized that the illustrated embodiments are only preferred examples and should not be taken as limiting the scope of the disclosure.

## Claims

1. A method for charged particle beam (CPB) phase contrast imaging, comprising:

   situating a CPB phase plate to be traversed by a CPB from a sample;
   situating the CPB phase plate to have a displacement $\Delta$ from a diffraction plane; and
   obtaining a sample image based on at least a portion of a CPB received from the CPB phase plate.

2. The method of claim 1, further comprising compensating the obtained sample image based on the diffraction plane displacement $\Delta$.

3. The method of claim 1, further comprising determining a transverse displacement of the CPB with respect to the CPB phase plate based on the obtained sample image.

4. The method of claim 3, further comprising adjusting a transverse position of the CPB with respect to the CPB phase plate based on the determined transverse displacement.

5. The method of claim 4, wherein the adjusting the transverse position of the CPB with respect to the CPB phase plate is performed by deflecting the CPB.

6. The method of claim 1, wherein the diffraction plane displacement $\Delta$ is selected so that the diffraction plane is optically downstream or upstream from the CPB phase plate.

7. The method of claim 3, wherein the CPB phase plate is a laser phase plate and the transverse displacement is associated with a separation of a CPB axis with respect to an antinode of a standing wave optical field established by the laser phase plate.

8. The method of claim 7, wherein the transverse displacement is less than or equal to P/8, wherein P is a period of the standing wave optical field.

9. The method of claim 7, further comprising identifying at least a portion of a laser fringe in the obtained sample image, wherein the transverse displacement of the CPB with respect to the laser phase plate is determined based on the portion of the laser fringe.

10. The method of claim 9, further comprising adjusting intensity of at least selected portions of the sample image based on an amplitude of the laser fringe.

11. The method of claim 10, wherein the diffraction plane displacement is selected so that the portion of the laser fringe corresponds to less than P/2.

12. The method of claim 7, further comprising adjusting an intensity of at least selected portions of the sample image based on an amplitude of a laser fringe, wherein the standing wave optical field produced by the laser phase plate extends and is periodic along an axis that is substantially orthogonal to the CPB axis and has a period based on a wavelength of the standing wave optical field, wherein the transverse displacement of the CPB axis from an antinode of the standing wave optical field is selected to be less than 1/8 of a period P of the standing wave optical field.

13. The method of claim 1, wherein the CPB phase plate is a laser phase plate that defines a standing wave optical field, and further comprising:

combining sample image values in an image window along a direction that is orthogonal to a phase axis of the CPB phase plate to produce an image intensity profile; and
based on the image intensity profile, determining a transverse displacement of the CPB axis from an antinode of the standing wave optical field.

14. A charged particle beam (CPB) apparatus, comprising:

a CPB phase plate situated to receive a CPB from a sample; and
at least one CPB lens situated to define a diffraction plane that is displaced a distance $\Delta$ from the CPB phase plate and form a sample image at a CPB detector, wherein the sample image is based on a phase applied to the CPB by the CPB phase plate.

15. The CPB apparatus of claim 14, further comprising an image processor operable to compensate the sample image based on the diffraction plane displacement $\Delta$.

FIG. 1B

FIG. 1A

FIG. 1C

FIG. 1D

FIG. 1E

FIG. 1F

104  151  152  153

161

101A

162

Δ

118

FIG. 1G

-1 diffraction
orders

+1 diffraction
orders

+X

FIG. 2A

PIXEL NUMBER K (Y-DIRECTION)

PIXEL NUMBER J (X-DIRECTION)

FIG. 2B

SUMMED INTENSITY $I_{SUM}(J)$ (ARBITRARY UNITS)

PIXEL NUMBER J (X-DIRECTION)

INCREASING Δ

INCREASING Δ

INCREASING Δ

302

FIG. 3A

320

FIG. 3B

322

312

EP 4 769 475 A1

FIG. 3C

FIG. 3D

FIG. 4

```
                                                          400
  ┌─────────────────────────────┐
  │  ESTABLISH LASER PHASE PLATE│
  │      OPTICAL FIELD          │
  └─────────────────────────────┘
                                      402
                 │
                 ▼
  ┌─────────────────────────────┐
  │ ADJUST TRANSVERSE CPB POSITION│
  │  WITH RESPECT TO THE LASER    │
  │  PHASE PLATE OPTICAL FIELD    │
  └─────────────────────────────┘
                                      404
                 │
                 ▼
  ┌─────────────────────────────┐
  │    ADJUST CPB THROUGH       │
  │    FOCUS BY DISTANCE Δ       │
  └─────────────────────────────┘
                                      406
                 │
                 ▼
  ┌─────────────────────────────┐
  │      ACQUIRE IMAGE          │   408
  └─────────────────────────────┘
                 │
                 ▼
       ┌──────────────────┐
       │   ADJUST IMAGE   │        410
       └──────────────────┘
                 │
                 ▼
        ◇ MORE IMAGES? ◇  412        ┌────────┐ 414
                                      │  END   │
                          NO          └────────┘
                 │ YES
                 ▼
  ┌─────────────────────────────┐
  │ EVALUATE IMAGE TO DETERMINE │   416
  │ RELATIVE POSITION OF CPB AND│
  │   LASER PHASE PLATE         │
  └─────────────────────────────┘
                 │
                 ▼
  ┌──────────┐  YES  ◇ POSITION ◇
  │  ADJUST  │◄──────   ERROR?
  │   CPB    │  420       418
  │TRANSVERSE│
  │ POSITION │        NO
  └──────────┘
```

ADJUST CPB THROUGH FOCUS BY DISTANCE Δ

FIG. 5

PROCESSOR
602

ADCs AND DACs 635

606

MONITOR
646

COMM.
CONNECTIONS 650

INPUT DEV. 640

IMAGE PROCESSING
TO DETERMINE CPB/
PHASE OFFSET
671

OUTPUT DEV. 645

SET CPB
DIFFACTION PLANE
OFFSET
672

STORAGE DEV.
630

COMPENSATE
IMAGES BASED ON
FRINGE PATTERN
673

RAM
610

MEMORY

604

608

BIOS
612

COMPENSATE
BROKEN FRIEDEL
SYMMETRY
674

690

CPB IMAGING
SYSTEM

600

REMOTE COMPUTER
660

MEM/
STORAGE
662

FIG. 6

FIG. 7A

FIG. 7B

OBTAIN IMAGE I(x) — 802

800

PROCESS IMAGE TO OBTAIN FOURIER TRANSFORM — 804

DETERMINE LEFT AND RIGHT PHASE SHIFTS BASED ON DIFFRACTION PLANE OFFSET Δ AND TRANSVERSE OFFSET ΔX — 806

SHIFT PHASE ORIGIN OF FOURIER TRANSFORM — 808

INVERSE FOURIER TRANSFORM PHASE SHIFTED FOURIER TRANSFROM TO PRODUCE IMAGE — 810

FIG. 8

**EUROPEAN SEARCH REPORT**

Application Number

EP 25 22 6297

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | EP 2 758 980 B1 (CAESAR STIFTUNG [DE] ET AL.) 15 March 2017 (2017-03-15) * paragraphs [0003], [0007], [0010], [0027] - [0031]; figures 1,3,4 * | 1-6,14, 15 | INV. H01J37/26 |
| | ----- | | |
| X | EP 2 333 809 B1 (HITACHI HIGH TECH CORP [JP]) 10 September 2014 (2014-09-10) | 1,2,14, 15 | |
| Y | * paragraphs [0011], [0046], [0094]; figure 5 * | 1-6,14, 15 | |
| | ----- | | |
| X | O. SCHWARTZ ET AL: "Laser control of the electron wave function in transmission electron microscopy", ARXIV.ORG CORNELL UNIVERSITY LIBRARY, 201 OLIN LIBRARY CORNELL UNIVERSITY ITHACA, NY 14853, 11 December 2018 (2018-12-11), XP080991868, | 1-9,14, 15 | |
| A | * the whole document * | 10-13 | |
| | ----- | | |

TECHNICAL FIELDS
SEARCHED (IPC)

H01J

The present search report has been drawn up for all claims

| Place of search | Date of completion of the search | Examiner |
|---|---|---|
| Munich | 16 May 2026 | Schmidt-Kärst, S |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 22 6297

This annex lists the patent family members relating to the patent documents cited in the above-mentioned European search report.
The members are as contained in the European Patent Office EDP file on
The European Patent Office is in no way liable for these particulars which are merely given for the purpose of information.

16-05-2026

| Patent document cited in search report | | Publication date | Patent family member(s) | | Publication date |
|---|---|---|---|---|---|
| EP 2758980 | B1 | 15-03-2017 | DE | 102011113645 A1 | 21-03-2013 |
| | | | EP | 2758980 A1 | 30-07-2014 |
| | | | WO | 2013041413 A1 | 28-03-2013 |
| EP 2333809 | B1 | 10-09-2014 | EP | 2333809 A1 | 15-06-2011 |
| | | | JP | 4896106 B2 | 14-03-2012 |
| | | | JP | 2010086691 A | 15-04-2010 |
| | | | US | 2011133084 A1 | 09-06-2011 |
| | | | WO | 2010038534 A1 | 08-04-2010 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **AXELROD**. *A Laser Phase Plate for Transmission Electron Microscopy*, 15 March 2024, https://arxiv.org/abs/2403.10670

- **AXELROD et al.** *Modern Approaches to Improving Phase Contrast Electron Microscopy*, 22 January 2024, https://arxiv.org/abs/2401.11678